# EUROPEAN PATENT APPLICATION

(11) **EP 0 991 306 A1**
(43) Date of publication of application: **05.04.2000**
(21) Application number: 99119252.7
(22) Date of filing: 28.09.1999
(51) Int. Cl.: H05K 3/38, C09J 179/00

(54) **Film for flexible printed wiring board**

(30) Priority: 29.09.1998 JP 27552698
(71) Applicant: Nisshinbo Industries, Inc., Chuo-ku, Tokyo 103-8650 (JP)
(72) Inventor: Imashiro,Yasuo, Nisshinbo Industries, Inc., Adachi-ku Tokyo 123-0843 (JP); Ito, Takahiko, Nisshinbo Industries, Inc., Adachi-ku Tokyo 123-0843 (JP); Tomita, Hideshi, Nisshinbo Industries, Inc., Adachi-ku Tokyo 123-0843 (JP); Nakamura, Norimasa, Nisshinbo Industries, Inc., Adachi-ku Tokyo 123-0843 (JP)
(74) Representative: Laufhütte, Dieter, Dr.-Ing.

(57) **Abstract**

The present invention provides a film (6) for flexible printed wiring board, constituted by a plastic film (4) and an adhesive layer (5) formed thereon, the adhesive layer (5) being made of a composition of a polycarbodiimide resin and an epoxy resin or a composition of a polycarbodiimide resin, an epoxy resin and a curing agent for epoxy resin.

The film for flexible printed wiring board alleviates the problems of the prior art and is characterized by enabling preliminary adhesion at relatively low temperatures, being low in dielectric constant after hot pressing, and showing superior adhesivity and heat resistance.

## Description

### Background of the Invention

### Field of the Invention

The present invention relates to a film for flexible printed wiring board. More particularly, the present invention relates to a film for flexible printed wiring board, which enables preliminary adhesion at relatively low temperatures, is low in dielectric constant after hot pressing, and shows superior adhesivity and heat resistance.

### Description of the Prior Art

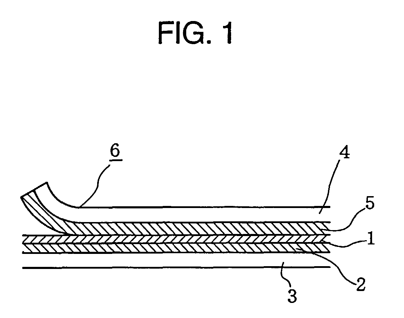

As shown in Fig. 1, flexible printed wiring boards are basically constituted by a conductor layer 1 made of copper or the like, a base film 3 having an adhesive layer 2 thereon, laminated on the lower side of the conductor layer 1 so that the adhesive layer 2 contacts with the conductor layer 1, and a cover lay film 6 which is an insulating film 4 having an adhesive layer 5 thereon, laminated on the upper side of the conductor layer 1 so that the adhesive layer 5 contacts with the conductor layer 1.

As the base film or cover lay film used in such flexible printed wiring boards, there are known, for example, a film obtained by coating, on one side of an insulating plastic (e.g. polyimide or polyester) film, an adhesive which is a composition comprising an epoxy resin and/or a phenolic resin and a thermoplastic resin (e.g. an acrylic resin) (see JP-A-7-273434); a film obtained by using an imide type resin as an adhesive (see JP-A-7-216313); and a three-layered cover lay film wherein two of the three layers are adhesive layers.

Each of these films has problems. In the film obtained by coating, on one side of an insulating plastic film, an adhesive which is a composition comprising an epoxy resin and/or a phenolic resin and a thermoplastic resin (e.g. an acrylic resin), the workability of lamination and the heat resistance are insufficient.

In the film obtained by using an imide type resin as an adhesive, temporary adhesion by low-temperature heating is impossible because the imide type resin begins to adhere at a high temperature, making the film unusable in printed wiring boards (in particular, flexible printed wiring boards) which require high-accuracy registration and consequently a temporary adhesion step.

In the three-layered cover lay film wherein two of the three layers are adhesive layers, a problem of high cost exists owing to the three-layered structure.

### Summary of the Invention

The object of the present invention is to alleviate the above-mentioned problems of the prior art and provide a film for flexible printed wiring board, which enables preliminary adhesion at relatively low temperatures, is low in dielectric constant after hot pressing, and shows superior adhesivity and heat resistance.

According to the present invention, there is provided a film for flexible printed wiring board, constituted by a plastic film and an adhesive layer formed thereon, the adhesive layer being made of a composition of a polycarbodiimide resin and an epoxy resin or a composition of a polycarbodiimide resin, an epoxy resin and a curing agent for epoxy resin.

### Brief Description of the Drawing

Fig. 1 is a perspective view showing the structure of a flexible printed wiring board using a film of the present invention.

In Fig. 1, numeral 1 refers to a conductor layer; numeral 2 refers to an adhesive layer; numeral 3 refers to a base film; numeral 4 refers to an insulating film; numeral 5 refers to an adhesive layer; and numeral 6 refers to a cover layer film.

### Detailed Description of the Invention

The present invention is hereinafter described in detail.

As the plastic film used in the present invention, there can be mentioned, for example, films made of a polyimide, a polyester, a polyphenylene sulfide, a polyethersulfone, a polycarbonate, a polyetheretherketone and a polyarylate. However, the plastic film is not restricted to these.

The present film for flexible printed wiring board, when the plastic film used therein is an insulating film, can be used as the same cover lay film as in the prior art. The insulating film can be a film having a thickness of, for example, 10 to 250 µm, made of one of the above-mentioned materials.

The present film for flexible printed wiring board, when the plastic film used therein is a base film, can be used as the same base film as in the prior art. The base film can be a film having a thickness of, for example, 10 to 250 µm, made of one of the above-mentioned materials.

The base film and the insulating film may have been subjected as necessary to a surface treatment such as corona discharging, low-temperature plasma treatment, physical surface-roughening treatment or the like. Preferably, the base film and the insulating film are made of the same material and have the same thickness in order to obtain good mechanical properties.

The composition used in the present invention comprises, in one case, a polycarbodiimide resin and an epoxy resin. As this polycarbodiimide resin, there can be used those produced by various methods. There can be used isocyanate-terminated polycarbodiimides produced fundamentally by the conventional method for producing a polycarbodiimide [U.S.P. 2,941,956; JP-B-47-33,279; J. Org. Chem., 28, 2069-2075 (1963); Chemical Review 1981, vol. 81, No. 4, pages 619-621], specifically by the carbon dioxide removal and condensation reaction of an organic polyisocyanate.

In the above-mentioned method, as the organic polyisocyanate which is the starting material for synthesizing the polycarbodiimide compound, there can be used, for example, aromatic polyisocyanates, aliphatic polyisocyanates, alicyclic polyisocyanates and mixtures thereof, and specifically, there can be mentioned 1,5-naphthalene diisocyanate, 4,4'-diphenylmeth ane diisocyanate, 4,4'-diphenyldimethylmethane diisocyanate, 1,3-phenylene diisocyanate, 1,4-phenylene diisocyanate, 2,4-tolylene diisocyanate, 2,6-tolylene diisocyanate, a mixture of 2,4-tolylene diisocyanate and 2,6-tolylene diisocyanate, hexamethylene diisocyanate, cyclohexane-1,4-diisocyanate, xylylene diisocyanate, isophorone diisocyanate, dicyclohexylmethane-4,4'-diisocyanate, methylcyclohexane diisocyanate, tetramethylxylylene diisocyanate, 2,6-diisopropylphenyl diisocyanate, and 1,3,5-triisopropylbenzene-2,4-diisocyanate.

Among them, those obtained from at least one aromatic polyisocyanate are preferable as the polycarbodiimide resin to be used in the present invention. Incidentally, the aromatic polyisocyanate refers to an isocyanate having, in the molecule, at least two isocyanate groups bonded directly to the aromatic ring.

As the above-mentioned polycarbodiimide, there can also be used those polycarbodiimides whose terminals are blocked with a compound (e.g. a monoisocyanate) reactive with the terminal isocyanates of polycarbodiimide and whose polymerization degrees are controlled at an appropriate level.

As the monoisocyanate for blocking the terminals of polycarbodiimide to control the polymerization degree thereof, there can be mentioned, for example, phenyl isocyanate, tolylene isocyanate, dimethylphenyl isocyanate, cyclohexyl isocyanate, butyl isocyanate, and naphthyl isocyanate.

As the other compounds reactive with the terminal isocyanates of polycarbodiimide, there can be used, for example, aliphatic compounds, aromatic compounds or alicyclic compounds having -OH group (such as methanol, ethanol, phenol, cyclohexanol, N-methylethanolamine, polyethylene glycol monomethyl ether, polypropylene glycol monomethyl ether and the like), =NH group (such ad diethylamine, dicyclohexylamine and the like), -NH₂ group (such as butylamine, cyclohexylamine and the like), -COOH group (such as propionic acid, benzoic acid, cyclohexanecarboxylic acid and the like), -SH group (such as ethylmercaptan, allylmercaptan, thiophenol and the like), epoxy group, or the like.

The carbon dioxide removal and condensation reaction of the above organic polyisocyanate proceeds in the presence of a carbodiimidation catalyst. As the carbodiimidation catalyst, there can be used, for example, phosphorene oxides such as 1-phenyl-2-phosphorene-1-oxide, 3-methyl-1-phenyl-2-phosphorene-1-oxide, 1-ethyl-2-phosphorene-1-oxide, 3-methyl-2-phosphorene-1-oxide, 3-phosphorene isomers thereof, and the like. Among them, 3-methyl-1-phenyl-2-phosphorene-1-oxide is suitable from the standpoint of reactivity.

The polycarbodiimide resin used in the present invention has a polystyrene-reduced number-average molecular weight of 3,000 to 50,000, preferably 10,000 to 30,000, and more preferably 15,000 to 25,000, as measured by gel permeation chromatography (GPC) regardless of whether or not the above-mentioned terminal-blocking agent is used. When the number-average molecular weight is smaller than 3,000, no sufficient film-formability or heat resistance can be obtained. When the number-average molecular weight exceeds 50,000, a long period of time is required for the synthesis of polycarbodiimide resin and, in addition, the polycarbodiimide resin varnish obtained has an extremely short pot life (service life). Therefore, such number-average molecular weights are not practical.

As the epoxy resin used in the present invention, there can be mentioned epoxy resins having at least two epoxy groups in the molecule, for example, glycidyl ether type epoxy resins, representatives of which are bisphenol A type epoxy resins, bisphenol F type epoxy resins, phenolic novolac type epoxy resins and cresol novolac type epoxy resins; alicyclic epoxy resins; glycidyl ester type epoxy resins; heterocyclic epoxy resins; and liquid rubber-modified epoxy resins. They are used alone or in admixture of two or more. Preferable are bisphenol A type epoxy resins, bisphenol F type epoxy resins, phenolic novolac type epoxy resins and cresol novolac type epoxy resins. However, the epoxy resins used in the present invention are not limited to them and all generally known epoxy resins may be used.

The composition used in the present invention comprises, in other case, a polycarbodiimide resin, an epoxy resin and a curing agent for epoxy resin. As the curing agent for epoxy resin, there can be used, for example, one kind of compound selected from those generally known as a curing agent for epoxy resin, such as polyamines, acid anhydrides, polyphenols, polymercaptans and the like, or a mixture thereof.

As specific examples of the curing agent for epoxy resin, there can be mentioned diethylenetriamine, triethylenetetramine, tetraethylenepentamine, triethylenediamine, isophoronediamine, N-aminoethylpiperazine, 3,9-bis(3-aminopropyl)-2,4,8,10-tetraoxyspiro-(5,5')undecane adduct, dicyandiamide, diaminodiphenylsulfone, phenylenediamine, phthalic anhydride, tetrahydrophthalic anhydride, methylnadic anhydride, pyromellitic anhydride, phenolic novolac and polymercaptan.

In the composition used in the present invention, the proportions of the polycarbodiimide resin and the epoxy resin can be, for example, 100 parts by weight for the former and 20 to 200 parts by weight, preferably 40 to 150 parts by weight, more preferably 50 to 100 parts by weight for the latter. When the proportion of the epoxy resin is smaller than 20 parts by weight, the properties of the epoxy resin hardly appear in the resulting composition. When the proportion of the epoxy resin is larger than 200 parts by weight, the resulting composition has inferior film formability. Therefore, none of such proportions is preferred.

When the curing agent for epoxy resin is used, the amount of the curing agent used is 10 parts by weight or smaller per 100 parts by weight of the epoxy resin. When the amount is larger than 10 parts by weight, the resulting polycarbodiimide resin-epoxy resin-curing agent composition has a short service life (storage period) and is not practical.

The mixing of the polycarbodiimide resin and the epoxy resin or of the polycarbodiimide resin, the epoxy resin and the curing resin for epoxy resin can be conducted, for example, by mixing them at room temperature, or by mixing them with heating, or by dissolving the epoxy resin in an appropriate solvent and then mixing all components. There is no particular restriction as to the method for mixing.

The formation, on the plastic film, of an adhesive layer made of the composition comprising the polycarbodiimide resin and the epoxy resin or the composition comprising the polycarbodiimide resin, the epoxy resin and the curing agent for epoxy resin can be made as follows. The composition is made into a varnish, the varnish is coated on the plastic film by a known method using a comma coater or a roll coater, and the resulting material is dried to remove the solvent contained in the varnish. Alternatively, the varnish obtained as above is coated on a polyethylene terephthalate substrate or the like which had been subjected to a treatment for easy release, and dried to form a B-stage film on the substrate, and the film is peeled and hot-pressed on the plastic film.

The thickness of the adhesive layer can be, for example, 5 to 50 µm. The thickness need not be different between when the plastic film is an insulating film and when the plastic film is a base film.

The production of a flexible printed wiring board using the present film obtained as above can be conducted, for example, by hot-pressing the film of the present invention for flexible printed wiring board on the circuit side of a flexible printed wiring board, using a hot roll (e.g. a roll laminator) or a press. In the hot-pressing, the temperature is 100 to 350°C and the time is at least 3 minutes, preferably 5 to 120 minutes.

In the above production of a flexible printed wiring board, the workability is very high because the present film for flexible printed wiring board enables temporary adhesion.

Further, the present film for flexible printed wiring board is low in dielectric constant after hot pressing and is superior in adhesivity and heat resistance.

### Description of the Preferred Embodiments

The present invention is hereinafter described in more detail by way of Examples. In the Examples, description is made on cover lay films, but the description is applicable to base films as well.

### Synthesis Examples 1 to 5 [Synthesis of polycarbodiimides]

Various polycarbodiimides were synthesized each in a varnish form under the conditions shown in Table 1, in a reactor equipped with a stirrer and a condenser.

**Table 1**

| | Synthesis Examples | | | | |
|---|---|---|---|---|---|
| | 1 | 2 | 3 | 4 | 5 |
| MDI^{a)} (g) | 172 | 172 | 172 | 0 | 0 |
| TDI^{b)} (g) | 0 | 0 | 0 | 174 | 174 |
| PI^{c)} (g) | 1.64 | 6.56 | 0.82 | 2.38 | 47.6 |
| THF^{d)} (g) | 1290 | 1290 | 1290 | 0 | 0 |
| Toluene (g) | 0 | 0 | 0 | 1200 | 1200 |
| Catalyst ^{e)} (g) | 0.34 | 0.34 | 0.34 | 0.34 | 0.44 |
| Reaction temp. (°C) | 70 | 70 | 70 | 100 | 100 |
| Reaction time (hr) | 15 | 10 | 18 | 14 | 10 |
| Mn^{f)} | 2.0 x 10⁴ | 5.2 x 10³ | 3.9 x 10⁴ | 2.1 x 10⁴ | 8.9 x 10³ |

| | | | | | |
|---|---|---|---|---|---|
| a) 4,4'-Diphenylmethane diisocyanate | | | | | |
| b) Tolylene diisocyanate | | | | | |
| c) Phenyl isocyanate | | | | | |
| d) Tetrahydrofuran (solvent) | | | | | |
| e) 3-Methyl-1-phenyl-2-phosphorene-1-oxide | | | | | |
| f) Polystyrene-reduced number-average molecular weight as measured by GPC | | | | | |

### Examples 1 to 6 and Comparative Examples 1 to 4

Using each of the polycarbodiimide varnishes obtained in the above Synthesis Examples 1 to 5, mixing, stirring and concentration were conducted in a formulation shown in Table 2 to prepare an adhesive composition. The adhesive composition was coated on a 25 µm-thick polyimide film [Kapton 100H (a trade name), a product of DuPont-Toray Co., Ltd.] and dried at 70°C for 30 minutes to obtain various cover lay films.

**Table 2**

| | Polycarbodiimide varnish used | Polycarbodiimide resin/epoxy resin^{a)}/curing agent^{b)} (weight ratio of solid contents) |
|---|---|---|
| Example 1 | Synthesis Example 1 | 100/70/0 |
| Example 2 | Synthesis Example 1 | 100/130/0 |
| Example 3 | Synthesis Example 2 | 100/100/0 |
| Example 4 | Synthesis Example 3 | 100/50/0 |
| Example 5 | Synthesis Example 4 | 100/70/0 |
| Example 6 | Synthesis Example 1 | 100/70/3.5 |
| Comparative Example 1 | Synthesis Example 1 | 100/0/0 |
| Comparative Example 2 | - | 0/100/0 |
| Comparative Example 3 | - | 0/100/10 |
| Comparative Example 4 | Synthesis Example 5 | 100/70/0 |

| | | |
|---|---|---|
| a) Epikote 828 (a trade name, a product of Yuka Shell Epoxy K.K.) | | |
| b) 3,3',5,5'-Tetramethyl-4,4'-diaminodiphenylmethane | | |

The cover lay films obtained in the above Examples 1 to 6 and Comparative Examples 1 to 4 were measured for the following properties according to the following test methods.

### (1) Preparation of test samples

Each cover lay film was laminated on the glossy surface of a 35 µm-thick electrolytic copper foil (a product of Nikko Gould Foil) under the press conditions of 180°C, 30 kg/cm² and 30 minutes, whereby each test sample was prepared.

### (2) Peeling strength

The test sample prepared in the above (1) was measured for peeling strength in accordance with JIS C 6481.

### (3) Resistance to soldering heat

Each test sample of 25 mm x 25 mm prepared according to the preparation procedure of above (1) was floated on a solder bath of 260°C for 60 seconds to examine the occurrence of foaming.

### (4) Through-hole life

In each test sample prepared in the above (1) was made a through-hole. The resulting sample was subjected to a heat cycle test in which a cycle consisting of -65°C x 30 minutes and 125°C x 30 minutes was repeated. The number of cycles when the total resistance of the sample increased by 15% or more, was defined as the "through-hole life" of the sample for evaluation of the reliability of the sample.

### (5) Dielectric constant and dielectric loss tangent

Values at 1 MHz were measured in accordance with JIS K 6911, using HP-4284A LCR meter (a product of Hewlett-Packard).

The test results are shown in Table 3.

**Table 3**

| Cover lay film | Peeling strength (kg/cm) | Resistance to soldering heat^{a)} | Through-hole life | Dielectric constant | Dielectric loss tangent |
|---|---|---|---|---|---|
| Ex. 1 | 1.7 | o | >500 | 3.6 | 0.008 |
| Ex. 2 | 1.6 | o | >500 | 3.7 | 0.007 |
| Ex. 3 | 1.3 | o | >500 | 3.6 | 0.007 |
| Ex. 4 | 1.5 | o | >500 | 3.5 | 0.007 |
| Ex. 5 | 1.5 | o | >500 | 3.7 | 0.005 |
| Ex. 6 | 1.8 | o | >500 | 3.9 | 0.009 |
| Comp. Ex. 1 | 0.7 | o | >500 | 3.4 | 0.003 |
| Comp. Ex. 2 | b) | b) | b) | b) | b) |
| Comp. Ex. 3 | 1.3 | o | 350 | 4.8 | 0.04 |
| Comp. Ex. 4 | 0.5 | x | 400 | 4.0 | 0.02 |

| | | | | | |
|---|---|---|---|---|---|
| a) o: There was neither swelling nor peeling. x: There were swelling and peeling. | | | | | |
| b) Measurement was impossible because sample preparation was impossible. | | | | | |

The film for flexible printed wiring board according to the present invention becomes very soft only by slight heating and exhibits adhesivity; therefore, enables preliminary adhesion at relatively low temperatures. Further, as shown in the above Examples, the present film, when sufficiently cured, exhibits excellent heat resistance and adhesivity: therefore, the present film is suitable for use in a production of printed wiring board.

Furthermore, the present film for flexible printed wiring board is low in dielectric constant after hot pressing.

## Claims

1. A film for flexible printed wiring board, constituted by a plastic film and an adhesive layer formed thereon, the adhesive layer being made of a composition of a polycarbodiimide resin and an epoxy resin.

2. A film for flexible printed wiring board, constituted by a plastic film and an adhesive layer formed thereon, the adhesive layer being made of a composition of a polycarbodiimide resin, an epoxy resin and a curing agent for epoxy resin.

3. A film for flexible printed wiring board according to Claim 1 or 2, wherein the plastic film is an insulating film.

4. A film for flexible printed wiring board according to Claim 1 or 2, wherein the plastic film is a base film.

5. A film for flexible printed wiring board according to Claim 1 or 2, wherein the polycarbodiimide resin is produced from at least one kind of aromatic polyisocyanate.

6. A film for flexible printed wiring board according to Claim 1 or 2, wherein the polycarbodiimide resin has a polystyrene-reduced number-average molecular weight of 3,000 to 50,000 as measured by gel permeation chromatography.

7. A film for flexible printed wiring board according to Claim 1 or 2, wherein the proportion of the epoxy resin in the composition is 20 to 200 parts by weight per 100 parts by weight of the polycarbodiimide resin.

8. A flexible printed wiring board using a film set forth in any of Claims 1 to 7.
